# EUROPEAN PATENT SPECIFICATION

(11) **EP 0 921 439 B1**
(45) Date of publication and mention of the grant of the patent: **03.03.2004**
(21) Application number: 98309875.7
(22) Date of filing: 02.12.1998
(51) Int. Cl.: G03F 7/00, G03F 7/039, G03F 7/004, C08F 222/06

(54) **Photosensitive polymer and chemically amplified resist composition using the same**
Photoempfindliches Polymer und dieses enthaltende chemisch verstärkte Resistzusammensetzung
Polymère photosensible et composition chimiquement amplifiée pour réserve contenant ce polymère

(30) Priority: 02.12.1997 KR 6511597
(43) Date of publication of application: 09.06.1999
(73) Proprietor: Samsung Electronics Co., Ltd., Suwon, Kyungi-do (KR)
(72) Inventor: Choi, Sang-Jun, Bundang-gu, Sungnam-shi, Kyunggi-do (KR); Kang, Yool, Sungnam-shi, Kyunggi-do (KR); Jung, Dong-Won, Seoul (KR); Park, Chun-Geun, Suwon, Kyunggi-do (KR)
(74) Representative: Andrews, Timothy Stephen

(56) References cited:
- EP-A- 0 789 278
- EP-A- 0 794 458
- EP-A- 0 836 119

## Description

The present invention relates to photosensitive polymers used in chemically amplified resist compositions, and resist compositions including such polymers.

With increasing integration of semiconductor devices, there is a heightened need for resists which can be formed into finer patterns of sub-quarter micron capacity in photolithography processes. A photolithography technology has been proposed which may use an ArF excimer laser (e.g., λ=193 nm) for devices beyond the 1 giga capacity. This technology is intended to replace the conventional ArF excimer layers using deep ultraviolet rays (λ=248 nm). Accordingly, it is desirable to develop new chemically amplified resist compositions.

Generally, the prerequisites for chemically amplified resist compositions for use with an ArF excimer laser are as follows:
(1) excellent transmittance in the range of 193 nm;
(2) excellent thermal characteristics, such as for example, high glass transition temperature (Tg);
(3) excellent adhesion to film materials;
(4) excellent resista nce against a dry etching process;
(5) capacity of being developed using a conventional alkaline developer, such as 2.38 wt% tetramethylammonium hydroxide (TMAH).

An example of one polymer which has been developed possibly to possess the above properties is a terpolymer, namely poly(MMA-tBWA-MAA) which is represented by the general formula:

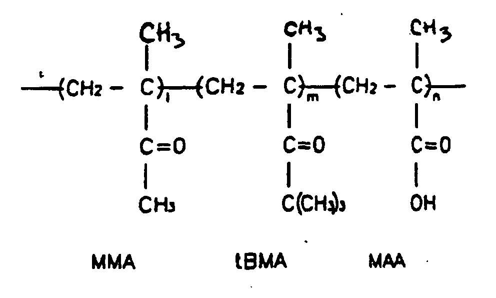

The above polymer is not satisfactory. In particular, the terpolymer has a very weak resistance against the etching process and has weak adhesive properties. Additionally, a special developer may be needed for the development of the terpolymer. To potentially address the above problems, a class of alicyclic compounds having groups such as isobornyl, adamantyl, and tricyclodecanyl groups has been proposed.

These alicyclic group-containing polymers however, also potentially suffer from drawbacks. Specifically, the alicyclic compounds may have weak adhesive properties and as a result lifting may possibly occur at the resist. Moreover, the alicyclic compounds may have a weak resistance against the dry etching process and a special developer, which may require separate preparation and may have to be employed in a specific concentration range, might have to be used with the above alycyclic compounds in place of generally accepted developers.

EP-A-0836119, which was published after the priority date of the present application but has an earlier priority date, discloses copolymers derived from 2-(1-hydroxyethyl)-norbomene and maleic anhydride and 2-(1-hydroxy-1-cyclohexylmethyl)norbornene and maleic anhydride. Furthermore, it discloses a chemically amplified photoresist composition comprising a photoacid generator and a polymer derived from either 2-(1-hydroxyethyl)-norbomene or 2-(1-hydroxy-1-cyclohexylmethyl)norbornene and maleic anhydride and tert-butyl(meth)acrylate.

In view of the above, it is an object of the invention to provide photosensitive polymers for use in chemically amplified resists which may be exposed to light using ArF laser, may have strong resistance to the dry etching process, may possess excellent adhesion to film materials, and may be developed using conventional developers.

It is a further object of the invention to provide chemically amplified resists containing such photosensitive polymers.

These and other objects, features, and advantages of the present invention are provided by photosensitive polymers for use in chemically amplified resists. The copolymers are of the general formula (I):

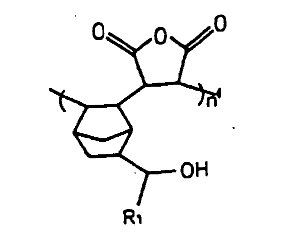

In the above formula (I), R₁ is selected from the group consisting of C₂ to C₂₀ aliphatic hydrocarbons, provided that R₁ is not cyclohexyl, and n' represents an integer. Particularly, R₁ is selected from the group consisting of ethyl and n-butyl or R₁ is selected from the group consisting of C₇ to C₂₀ alicyclic aliphatic hydrocarbons, said group containing moieties such as adamantyl, norbornyl, and isobornyl groups. The copolymers have a weight average molecular weight ranging from 3,000 to 100,000.

In another aspect, the invention provides a resist composition comprising terpolymers and photoacid generators. The terpolymers are of the general formula (II):

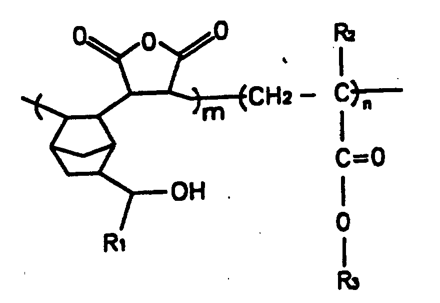

In the above formula (II), R₁ is selected from the group consisting of C₁ to C₂₀ aliphatic hydrocarbons; R₂ is hydrogen or a methyl group; R₃ is a t-butyl or tetrahydropyranyl groups; and n and m each represent integers, which are such that the ratio of n:(m+n) is from 0.1 to 0.5, provided that when R₂ is methyl and R₃ is t-butyl, R₁ is not methyl or cyclohexyl. Particularly, R₁ is selected from the group consisting of methyl, ethyl, n-butyl, and cyclohexyl or R₁ is selected from the group consisting of C₇ to C₂₀ alicyclic aliphatic hydrocarbons, said group containing moieties such as adamantyl, norbornyl, and isobornyl groups. The terpolymers have a weight average molecular weight ranging from 3,000 to 200,000. The photoacid generators may be present in amounts ranging from 1.0 wt% to 20.0 wt% based upon the weight of the terpolymers. The photoacid generators are selected from the group consisting of triarylsulfonium salts, diaryliodonium salts, and sulfonates. The triarylsulfonium salts composing the photoacid generators are selected from the group consisting of triphenylsulfonium triflate and triphenylsulfonium antimonate. The sulfonates composing the photoacid generators are selected from the group consisting of 2,6-dinitrobenzyl sulfonates and pyrogallol tris(alkylsulfonate) The diaryliodonium salts composing the photoacid generators are selected from the group consisting of diphenyliodonium triflate, diphenyliodonium antimonate, methoxydiphenyliodonium triflate, and di-t-butyldiphenyliodonium triflate.

The invention may be understood and its objects will become apparent to those skilled in the art by reference to the accompanying drawings as follows.
Fig. 1 represents a Fourier Transform Infrared Radiation (FTIR) spectrum of a terpolymer having tBMA units; and
Fig. 2 is a cross-sectional photograph of the 0.3µm line and space pattern obtained with the resist of Reference Example 4(a) which is not according to the present claims.

The preferred embodiments of the present invention will now be described fully hereinafter with reference to the accompanying drawings in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

The following examples are to be construed as illustrative of the present invention, and not as a limitation thereon.

### Synthesis EXAMPLE 1

### Synthesis of monomer:

### (a) Synthesis of 5-norbornene-2-cyclohexylmethanol

In this embodiment, a solution of 13 grams (0.1 mol) of 5-norbornene-2-carboxaldehyde was slowly dropped into a solution of 0.1 mol of cyclohexyl magnesiumbromide which had been dissolved in diethylether so as to form a reaction mixture. The reaction mixture was refluxed for about 12 hours and subsequently poured into an excess of water. Then, diethylether was added to the resultant solution and thereby the reaction product was extracted from the resultant solution. After drying the reaction product with anhydrous magnesium sulphate, the solution of the reaction product was evaporated under vacuum to remove the solvent, so that the 5-norbornene-2-cyclohexylmethanol could be extracted. The yield was 75%.

### (b) Synthesis of 5-norbornene-2-norbornylmethanol.

In this embodiment, a solution of 13 grams (0.1 mol) of 5-norbornene-2-carboxaldehyde was slowly dropped into a solution of 0.1 mol of 2-norbornyl magnesiumbromide which had been dissolved in tetrahydrofuran (THF) so as to form a reaction mixture. The reaction mixture was refluxed for about 20 hours. Then the THF was evaporated using a rotary evaporator and the reaction mixture was subsequently poured into an excess of water. Then, diethylether was added to the resultant solution and thereby the reaction product was extracted from the resultant solution. After drying the reaction product with anhydrous magnesium sulphate. the solution of the reaction product was evaporated under vacuum to remove the solvent, so that the 5-norbornene-2-norbornylmethanol could be extracted. The yield was 60%.

### (c) Synthesis of tetrahydropyranyl methacrylate.

In this embodiment, 0.1 mol of methacrylic acid and 8 6 grams (0.11 mol) of 3,4-dihydro-2H-pyran were dissolved in 150ml of CH₂Cl₂. Small amounts of p-toluenesulfonic acid were added into the resultant solution and then were allowed to react at room temperature for four hours so as to form a reaction product. The reaction mixture was then poured into an excess of water. Then, diethylether was added to the resultant solution and thereby the reaction product could be extracted from the resultant solution. After drying the reaction product with anhydrous magnesium sulphate, the solution of the reaction product was evaporated under vacuum to remove the solvent, so that the tetrahydropyranyl methacrylate could be extracted. The yield was 85%.

### EXAMPLE 2

### Synthesis of copolymer:

The synthesis reaction of the copolymer according to this embodiment can be represented by the following formula:

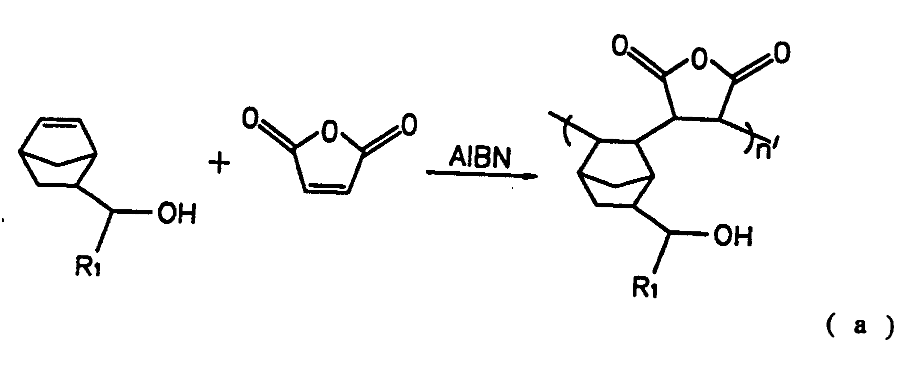

### (a) Synthesis of poly(norbornene-2-cyclohexylmethanol-alt-maleic anhydride). The polymer is not according to the present claims.

In this embodiment, 20 grams (0.1 mol) of 5-norbornene-2-cyclohexylmethanol and 10 grams (0.1 mol) of maleic anhydride were dissolved in 100 ml of THF, and 0.32 grams of AIBN (2,2'-azobisisobutyronitrile) were added thereto. The mixture was completely purged with nitrogen gas so as to form a reaction mixture.

The reaction mixture was refluxed for about 24 hours and subsequently the reaction product was precipitated in a ten-fold diluted excess of n-hexane. After that, the precipitates were dissolved in the THF again, and then reprecipitated as above in n-hexane. The resultant precipitates were filtered and then dried in a vacuum oven at 50°C for about 24 hours so as to obtain the poly(norbornene-2-cyclohexylmethanol-alt-maleic anhydride). The yield was 60%. The weight average molecular weight of the thus-obtained copolymer was 5000 and polydispersity (weight average molecular weight/number average molecular weight) was 2.1. The result of the FTIR spectrum analysis for the thus-obtained copolymer product was as follows:
FTIR (KBr): 3400 to 3600 cm⁻¹ (O-H), 1782 cm⁻¹ (C=O).

### (b) Synthesis of poly(norbornene-2-norbonylmethanol-alt-maleic anhydride).

In this embodiment, 21 grams (0.1 mol) of 5-norbornene-2-norbornylmethanol and 10 grams (0.1 mol) of maleic anhydride were dissolved in 100 ml of THF, and 0.32 grams of AIBN (2,2'-azobisisobutyronitrile) were added thereto. The mixture was completely purged with nitrogen gas so as to form a reaction mixture.

The reaction mixture was refluxed for about 24 hours and subsequently the reaction product was precipitated in a ten-fold diluted excess of n-hexane. After that, the precipitates were dissolved in THF again, and then reprecipitated as above in n-hexane. The resultant precipitates were filtered and then dried in a vacuum oven at 50°C for about 24 hours so as to obtain the poly(norbornene-2-norbornylmethanol-alt-maleic anhydride). The yield was 65% The weight average molecular weight of the thus-obtained copolymer was 4700 and polydispersity (weight average molecular weight/number average molecular weight) was 2.0.

The result of the FTIR spectrum analysis for the thus-obtained copolymer product was as follows:
FTIR (KBr) 3400 to 3600 cm⁻¹ (-O-H), 1780 cm⁻¹ (C=O).

### EXAMPLE 3

### Synthesis of terpolymer.

The synthesis reaction of the terpolymer according to this embodiment can be represented by the following formula:

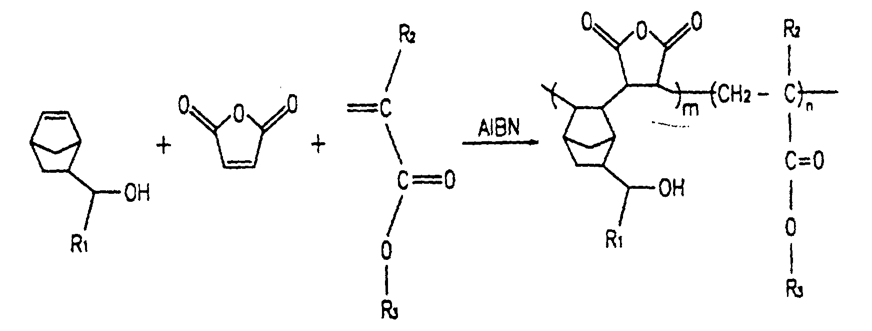

### (a) Synthesis of terpolymer wherein R₃ is a t-butyl group (terpolymer not according to the claims)

In this embodiment, 20 grams (0.1 mol) of 5-norbornene-2-cyclohexylmethanol. 10 grams (0.1 mol) of maleic anhydride, and 14 grams (0.1 mol) of t-butyl methacrylate (t-BMA) were dissolved in 150ml of THF, and 0.49 grams of AIBN were added thereto. The mixture was completely purged with nitrogen gas so as to form reaction mixture.

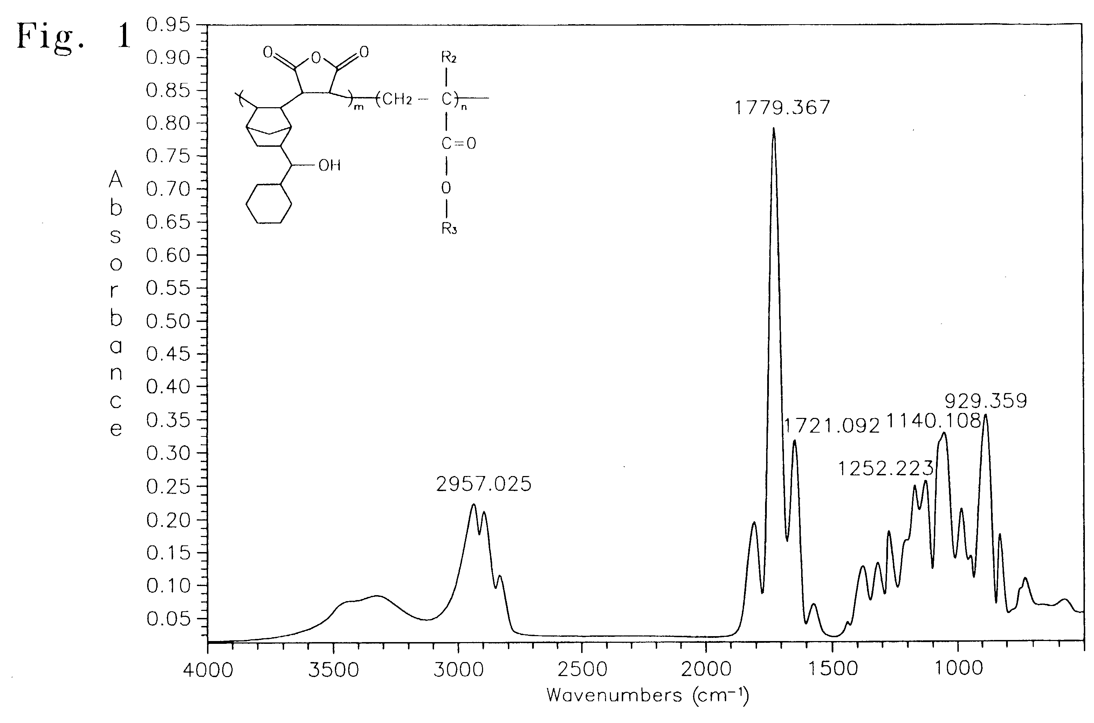

The reaction mixture was refluxed for about 24 hours and then the reaction product was precipitated in a ten-fold diluted excess of n-hexane. After that, the precipitates were dissolved in THF again, and then reprecipitated as above in n-hexane. The thus-obtained precipitates were filtered and then dried in a vacuum oven at 50°C for about 24 hours so as to obtain the poly(norbornene-2-norbornylmethanol-alt-maleic anhydride-tertbutyl methacrylate). The yield was 75%. The weight average molecular weight of the thus-obtained copolymer was 5500 and polydispersity (weight average molecular weight/number average molecular weight) was 2.1. Fig. 1 represents a Fourier Transform Infrared Radiation (FTIR) spectrum of the thus-obtained terpolymer having tBMA units according to this embodiment. The result of the FTIR spectrum analysis shown in Fig. 1 was as follows:
FTIR (KBr): 3400 to 3600 cm⁻¹ (O-H), 2789 cm⁻¹ (C-H), 1780 cm⁻¹ (C=O).

### (b) Synthesis of terpolymer wherein R₃ is a tetrahydropyranyl group.

In this embodiment, 20 grams (0.1 mol) of 5-norbornene-2-cyclohexylmethanol, 10 grams (0.1 mol) of maleic anhydride, and 17 grams (0.1 mol) of tetrahydropyranyl methacrylate (THPMA) were dissolved in 150ml of THF, and 0.49 grams of AIBN were added thereto. The mixture was completely purged with nitrogen gas so as to form a reaction mixture.

The reaction mixture was refluxed for about 24 hours and then the reaction product was precipitated in a ten-fold diluted excess of n-hexane. After that, the precipitates were dissolved in THF again, and then reprecipitated as above in n-hexane. The resultant precipitates were filtered and then dried in a vacuum oven at 50°C for about 24 hours so as to obtain the poly(norbornene-2-norbornylmethanol-alt-maleic anhydride-tertbutyl methacrylate). The yield was 75%. The weight average molecular weight of the thus-obtained copolymer was 5000 and polydispersity (weight average molecular weight/number average molecular weight) was 2.0.

The result of the FTIR spectrum analysis for the thus-obtained copolymer product was as follows:
FTIR (KBr): 3400 to 3600 cm⁻¹ (-O-H), 2957 cm⁻¹ (C-H), 1780 cm⁻¹ (C=O), 1720 cm⁻¹ (C=O).

### EXAMPLE 4

### Preparation of resist composition:

### (a) Preparation of resist composition utitizing terpolymer having a t-butyl group. (not according to the present claims)

In this embodiment, 1.0 grams of terpolymer having t-BMA units prepared in Example 3 and 0.05 grams of triphenylsulfonium triflate were completely dissolved in 6.0 grams of propyleneglycol monomethylether acetate (PGMEA). The mixture was stirred thoroughly. After that the mixture was filtered with a 0.45µm microfilter and then filtered again with a 0.2µm microfilter to thereby prepare a resist composition. The surface of a silicon wafer was treated with hexamethyldisilazane (HMDS), and then the thus-prepared resist composition was applied to the wafer thereby to form a coating film of about 0.5µm.

The wafer having the coating film was pre-baked at about 130°C for about 90 seconds. then exposed to light using a ArF excimer laser having a numeric aperture of 0.45 and then baked again at about 140°C for about 90 seconds.

Thereafter, the resultant wafer was developed for about 60 seconds by using about 2.38 wt% of tetramethyl ammonium hydroxide (TMAH) solution.

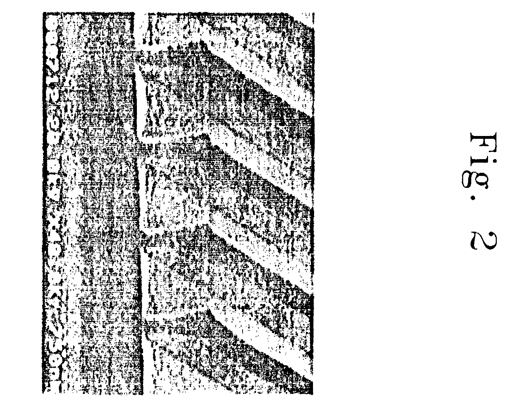

Fig. 2 is a cross-sectional photograph of the 0.3µm line and space pattern for the resist according to this embodiment. Referring to Fig. 2, the 0.3µm line and space pattern for the resist was obtained when the exposure energy was approximately 20mJ/cm².

### (b) Preparation of resist composition utilising terpolymer having tetrahydropyranyl group.

In this embodiment, 1.0 grams of terpolymer having THPMA units prepared in Example 3 and 0.05 grams of triphenylsulfonium triflate were completely dissolved in 6.0 grams of propyleneglycol monomethylether acetate (PGMEA). The mixture was stirred thoroughly. After that, the mixture was filtered with a 0.45µm microfilter and then filtered again with a 0.2µm microfilter to thereby prepare a resist composition. The surface of a silicon wafer was treated with hexamethyldisilazane (HMDS), and then the thus-prepared resist composition was applied to a wafer thereby to form a coating film of about 0 5µm.

The wafer having the coating film was baked at about 130°C for about 90 seconds, then exposed to light using a ArF excimer laser having a numeric aperture of 0.45 and then baked again at about 140°C for about 90 seconds.

Thereafter, the resultant wafer was developed for about 60 seconds by using about 2.38 wt% of tetramethyl ammonium hydroxide (TMAH) solution.

In this embodiment, the 0.3µm line and space pattern for the resist was obtained when the exposure energy was approximately 13mJ/cm².

### (c) Preparation of resist composition utilizing terpolymer having a tetrahydropyranyl group.

In this embodiment, 1.0 grams of terpolymer having THPMA units prepared in Example 3 and 0.05 grams of methoxydiphenyliodonium triflate were completely dissolved in 6.0 grams of propyleneglycol monomethylether acetate (PGMEA). The mixture was stirred thoroughly. After that, the mixture was filtered with a 0.45µm microfilter and then filtered again with a 0.2µm microfilter to thereby prepare a resist composition. The surface of a silicon wafer was treated with hexamethyldisilazane (HMDS), and then the thus-prepared resist composition was applied to a wafer thereby to form a coating film of about 0.5µm.

The wafer having the coating film was baked at about 130°C for about 90 seconds, then exposed to light using a ArF excimer laser having a numeric aperture of 0.45 and then baked again at about 140°C for about 90 seconds.

Thereafter, the resultant wafer was developed for about 60 seconds by using about 2.38 wt% of tetramethyl ammonium hydroxide (TMAH) solution.

In this embodiment, the 0.3µm line and space pattern for the resist was obtained when the exposure energy was approximately 18mJ/cm².

## Claims

1. A copolymer having the formula (I): 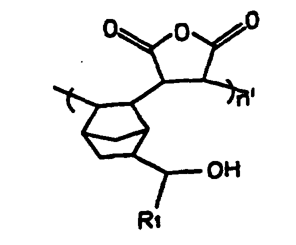 wherein R₁ is selected from the group consisting of C₂ to C₂₀ aliphatic hydrocarbons, provided that R₁ is not cyclohexyl, and n' is an integer.

2. The copolymer according to claim 1, wherein R₁ is selected from the group consisting of ethyl and n-butyl.

3. The copolymer according to claim 1, wherein R₁ is selected from the group consisting of C₇ to C₂₀ alicyclic aliphatic hydrocarbons.

4. The copolymer according to claim 3, wherein R₁ is selected from the group consisting of adamantyl, norbornyl and isobornyl groups.

5. The copolymer according to claim 1, wherein said copolymer has a weight average molecular weight of from 3,000 to 100,000.

6. A composition comprising a photoacid generator and a polymer having the formula (II): 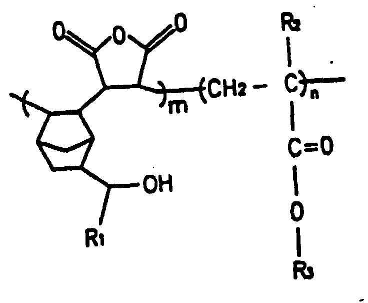 wherein:
R₁ is selected from the group consisting of C₁ to C₂₀ aliphatic hydrocarbons;
R₂ is selected from the group consisting of hydrogen and methyl;
R₃ is selected from the group consisting of t-butyl and tetrahydropyranyl;
n and m are each integers; and
the ratio of n: (m+n) ranges from about 0.1 to 0.5,
PROVIDED THAT when R₂ is methyl and R₃ is t-butyl, R₁ is not methyl or cyclohexyl.

7. The composition according to claim 6, wherein R₁ is selected from the group consisting of methyl, ethyl, n-butyl, and cyclohexyl groups, provided that when R₂ is methyl and R₃ is t-butyl, R₁ is not methyl or cyclohexyl.

8. The composition according to claim 6, wherein R₁ is selected from the group consisting of C₇ to C₂₀ alicyclic aliphatic hydrocarbons.

9. The resist composition according to claim 8, wherein R₁ is selected from the group consisting of adamantyl, norbornyl and isobornyl groups.

10. The composition according to any one of claims 6 to 9, wherein the amount of photoacid generator in the composition is in the range of 1.0 to 20 percent based upon the amount by weight of said polymer present.

11. The composition according to any one of claims 6 to 10, wherein said polymer has a weight average molecular weight of from 3,000 to 200,000.

12. The composition according to any one of claims 6 to 11, wherein said photoacid generator is selected from the group consisting of triarylsufonium salts, diaryliodonium salts, and sulfonates.

13. The composition according to claim 12, wherein said triarysulfonium salt is selected from the group consisting of triphenylsulfonium triflate and triphenylsulfonium antimonate.

14. The composition according to claim 12, wherein said sulfonate is selected from the group consisting of 2,6-dinitrobenzyl sulfonates and pyrogallol tris(alkylsulfonate).

15. The composition according to claim 12, wherein said diaryliodonium salt is selected from the group consisting of diphenyliodonium triflate, diphenyliodonium antimonate, methoxydiphenyliodonium triflate, and di-t-butyldiphenyliodonium triflate.

16. Use of a copolymer according to any one of claims 1 to 5 in a chemically amplified resist.

17. Use of a composition according to any one of claims 6 to 15 as a resist composition for use in a chemically amplified resist.

18. A chemically amplified resist prepared using a composition according to any one of claims 6 to 15.

19. A chemically amplified resist prepared using a copolymer according to any one of claims 1 to 5.

## Patentansprüche

1. Copolymer mit der Formel (I): 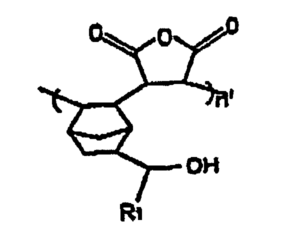 wobei R₁ aus der Gruppe, bestehend aus aliphatischen C₂- bis C₂₀-Kohlenwasserstoffen, ausgewählt ist, mit der Maßgabe, daß R₁ nicht Cyclohexyl ist und n' eine ganze Zahl ist.

2. Copolymer nach Anspruch 1, wobei R₁ aus der Gruppe, bestehend aus Ethyl und n-Butyl, ausgewählt ist.

3. Copolymer nach Anspruch 1, wobei R₁ aus der Gruppe, bestehend aus alicyclischen aliphatischen C₇- bis C₂₀-Kohlenwasserstoffen, ausgewählt ist.

4. Copolymer nach Anspruch 3, wobei R₁ aus der Gruppe, bestehend aus der Adamantyl-, Norbornyl- und Isobornylgruppe, ausgewählt ist.

5. Copolymer nach Anspruch 1, wobei das Copolymer ein gewichtsmittleres Molekulargewicht von 3000 bis 100000 hat.

6. Zusammensetzung, umfassend einen Photosäureerzeuger und ein Polymer mit der Formel (II): 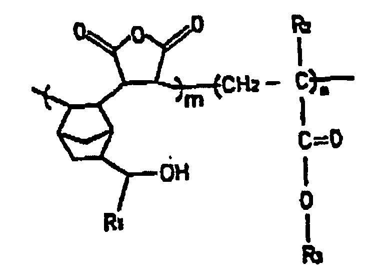 wobei: R₁ aus der Gruppe, bestehend aus aliphatischen C₁- bis C₂₀-Kohlenwasserstoffen, ausgewählt ist;
R₂ aus der Gruppe, bestehend aus Wasserstoff und Methyl, ausgewählt ist;
R₃ aus der Gruppe, bestehend aus t-Butyl und Tetrahydropyranyl, ausgewählt ist;
n und m jeweils ganze Zahlen sind; und
das Verhältnis von n:(m+n) von etwa 0,1 bis 0,5 reicht,
mit der Maßgabe, daß, wenn R₂ Methyl ist und R₃ t-Butyl ist, R₁ nicht Methyl oder Cyclohexyl ist.

7. Zusammensetzung nach Anspruch 6, wobei R₁ aus der Gruppe, bestehend aus der Methyl-, Ethyl-, n-Butyl- und Cyclohexylgruppe, ausgewählt ist, mit der Maßgabe, daß, wenn R₂ Methyl ist und R₃ t-Butyl ist, R₁ nicht Methyl oder Cyclohexyl ist.

8. Zusammensetzung nach Anspruch 6, wobei R₁ aus der Gruppe, bestehend aus alicyclischen aliphatischen C₇- bis C₂₀-Kohlenwasserstoffen, ausgewählt ist.

9. Resistzusammensetzung nach Anspruch 8, wobei R₁ aus der Gruppe, bestehend aus der Adamantyl-, Norbornyl- und Isobornylgruppe, ausgewählt ist.

10. Zusammensetzung nach einem der Ansprüche 6 bis 9, wobei der Anteil von Photosãureerzeuger in der Zusammensetzung in dem Bereich von 1,0 bis 20 Prozent, bezogen auf den Gewichtsanteil des vorhandenen Polymers, ist.

11. Zusammensetzung nach einem der Ansprüche 6 bis 10, wobei das Polymer ein gewichtsmittleres Molekulargewicht von 3000 bis 200000 hat.

12. Zusammensetzung nach einem der Ansprüche 6 bis 11, wobei der Photosäureerzeuger aus der Gruppe, bestehend aus Triarylsulfoniumsalzen, Diaryliodoniumsalzen und Sulfonaten, ausgewählt ist.

13. Zusammensetzung nach Anspruch 12, wobei das Triarylsulfoniumsalz aus der Gruppe, bestehend aus Triphenylsulfoniumtriflat und Triphenylsulfoniumantimonat, ausgewählt ist.

14. Zusammensetzung nach Anspruch 12, wobei das Sulfonat aus der Gruppe, bestehend aus 2,6-Dinitrobenzylsulfonaten und Pyrogalloltris(alkylsulfonat), ausgewählt ist.

15. Zusammensetzung nach Anspruch 12, wobei das Diaryliodoniumsalz aus der Gruppe, bestehend aus Diphenyliodoniumtriflat, Diphenyliodoniumantimonat, Methoxydiphenyliodoniumtriflat und Di-t-butyldiphenyliodoniumtriflat, ausgewählt ist.

16. Verwendung eines Copolymers nach einem der Ansprüche 1 bis 5 in einem chemisch verstärkten Resist.

17. Verwendung einer Zusammensetzung nach einem der Ansprüche 6 bis 15 als Resistzusammensetzung zur Verwendung in einem chemisch verstärkten Resist.

18. Chemisch verstärkter Resist, hergestellt unter Verwendung einer Zusammensetzung nach einem der Ansprüche 6 bis 15.

19. Chemisch verstärkter Resist, hergestellt unter Verwendung eines Copolymers nach einem der Ansprüche 1 bis 5.

## Revendications

1. Copolymère de formule (I): 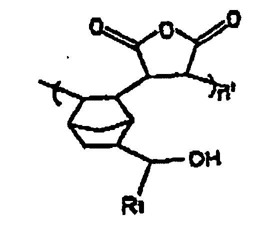 dans laquelle R₁ est choisi dans le groupe constitué des groupes hydrocarbonés aliphatiques en C₂ à C₂₀, à condition que R₁ ne soit pas un groupe cyclohexyle, et n' est un entier.

2. Copolymère selon la revendication 1, dans lequel R₁ est choisi dans le groupe constitué des groupes éthyle et n-butyle.

3. Copolymère selon la revendication 1, dans lequel R₁ est choisi dans le groupe constitué des groupes hydrocarbonés aliphatiques alicycliques en C₇ à C₂₀.

4. Copolymère selon la revendication 3, dans lequel R₁ est choisi dans le groupe constitué des groupes adamantyle, norbornyle et isobornyle.

5. Copolymère selon la revendication 1, dans lequel ledit copolymère a un poids moléculaire moyen en poids de 3000 à 100 000.

6. Composition comprenant un photogénérateur d'acide et un polymère de formule (II): 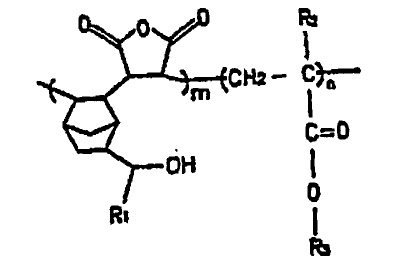 dans laquelle: R₁ est choisi dans le groupe constitué des groupes hydrocarbonés aliphatiques en C₁ à C₂₀, R₂ est choisi dans le groupe constitué d'un hydrogène et d'un groupe méthyle;
R₃ est choisi dans le groupe constitué des groupes t-butyle et tétrahydropyranyle;
m et n sont chacun des entiers; et
le rapport de n:(m+n) va d'environ 0,1 à 0,5,
à condition que lorsque R₂ est un groupe méthyle et R₃ est un groupe t-butyle, R₁ ne soit pas un groupe méthyle ni un groupe cyclohexyle.

7. Composition selon la revendication 6, dans laquelle R₁ est choisi dans le groupe constitué des groupes méthyle, éthyle, n-butyle, et cyclobexyle, à condition que lorsque R₂ est un groupe méthyle et R₃ est un groupe t-butyle, R₁ ne soit pas un groupe méthyle ni un groupe cyclohexyle.

8. Composition selon la revendication 6, dans laquelle R₁ est choisi dans le groupe constitué des groupes hydrocarbonés aliphatiques alicycliques en C₇ à C₂₀

9. Composition de réserve selon la revendication 8, dans laquelle R₁ est choisi dans le groupe constitué des groupes adamantyle, norbornyle et isobornyle.

10. Composition selon l'une quelconque des revendications 6 à 9, dans laquelle la quantité de photogénérateur d'acide dans la composition se situe dans la gamme de 1,0 à 20% par rapport à la quantité en poids dudit polymère présent.

11. Composition selon l'une quelconque des revendications 6 à 10, dans laquelle ledit polymère a un poids moléculaire moyen en poids de 3000 à 200 000.

12. Composition selon l'une quelconque des revendications 6 à 11, dans laquelle ledit photogénérateur d'acide est choisi dans le groupe constitué des sels de triarylsulfonium, des sels de diaryliodonium, et des sulfonates.

13. Composition selon la revendication 12, dans laquelle ledit sel de triarylsulfonium est choisi dans le groupe constitué du triflate de triphénylsulfonium et de l'antimoniate de triphénylsulfonium.

14. Composition selon la revendication 12, dans laquelle ledit sulfonate est choisi dans le groupe constitué des 2,6-dinitrobenzylsulfonates et du pyrogallol tris(alkylsulfonate).

15. Composition selon la revendication 12, dans laquelle ledit sel de diaryliodonium est choisi dans le groupe constitué du triflate de diphényliodonium, de l'antimoniate de diphényliodonium, du triflate de méthoxydiphényliodonium, et du triflate de di-t-butyldiphényliodonium.

16. Utilisation d'un copolymère selon l'une quelconque des revendications 1 à 5 dans une réserve chimiquement amplifiée.

17. Utilisation d'une composition selon l'une quelconque des revendications 6 à 15 comme composition de réserve à utiliser dans une réserve chimiquement amplifiée.

18. Réserve chimiquement amplifiée préparée en utilisant une composition selon l'une quelconque des revendications 6 à 15.

19. Réserve chimiquement amplifiée préparée en utilisant un copolymère selon l'une quelconque des revendications 1 à 5.
